# EUROPEAN PATENT SPECIFICATION

(11) **EP 2 494 087 B1**
(45) Date of publication and mention of the grant of the patent: **30.12.2020**
(21) Application number: 10771619.3
(22) Date of filing: 26.10.2010
(51) Int. Cl.: C23C 16/32, C23C 16/56, B05D 7/24, C23C 8/10

(54) **CHEMICAL VAPOR DEPOSITION METHOD**
CVD-BESCHICHTUNGSVERFAHREN
PROCÉDÉ DE DÉPÔT CHIMIQUE EN PHASE VAPEUR

(30) Priority: 27.10.2009 US 255237 P; 07.12.2009 US 267228 P
(43) Date of publication of application: 05.09.2012
(73) Proprietor: Silcotek Corp., Bellefonte, Pennsylvania 16823 (US)
(72) Inventor: SMITH, David A., Bellefonte Pennsylvania 16823 (US); MATTZELA, James B., State College Pennsylvania 16803 (US); SILVIS, Paul H., Port Matilda Pennsylvania 16870 (US); BARONE, Gary A., Bellefonte Pennsylvania 16823 (US)
(74) Representative: Pons
(86) International application number: PCT/US2010/054058
(87) International publication number: WO 2011/056550

(56) References cited:
- EP-A2- 0 812 013
- WO-A1-2009/032488
- SHINOHARA M ET AL: "Infrared study of carbon incorporation during chemical vapor deposition of SiC using methylsilanes", APPLIED SURFACE SCIENCE ELSEVIER NETHERLANDS, vol. 175-176, 15 May 2001 (2001-05-15), pages 591-596, XP002620548, ISSN: 0169-4332
- NARITA ET AL: "Interpretation of initial stage of 3C-SiC growth on Si(100) using dimethylsilane", APPLIED SURFACE SCIENCE, ELSEVIER, AMSTERDAM, NL, vol. 252, no. 10, 15 March 2006 (2006-03-15), pages 3460-3465, XP005294998, ISSN: 0169-4332, DOI: DOI:10.1016/J.APSUSC.2005.05.021
- VASIN A V ET AL: "Light-emitting properties of amorphous Si:C:O:H layers fabricated by oxidation of carbon-rich a-Si:C:H films", SOLID STATE SCIENCES, ELSEVIER, PARIS, FR, vol. 11, no. 10, 1 October 2009 (2009-10-01), pages 1833-1837, XP026653063, ISSN: 1293-2558, DOI: DOI:10.1016/J.SOLIDSTATESCIENCES.2009.05.0 30 [retrieved on 2009-06-06]

## Description

### FIELD OF THE INVENTION

The present disclosure is directed to chemical vapor deposition. More particularly, the disclosure is directed to chemical vapor deposition onto a substrate as a result of decomposition of dimethylsilane.

### BACKGROUND

Often, surfaces of substrates do not include desired performance characteristics. The failure to include specific desired performance characteristics can result in surface degradation in certain environments, an inability to meet certain performance requirements, or combinations thereof. For example, in certain environments, metallic, glass, and ceramic surfaces can be subjected to undesirable surface activities such as chemical adsorption, catalytic activity, corrosive attack, oxidation, byproduct accumulation or stiction, and/or other undesirable surface activities.

Undesirable surface activities can cause chemisorption of other molecules, reversible and irreversible physisorption of other molecules, catalytic reactivity with other molecules, attack from foreign species, a molecular breakdown of the surface, or combinations thereof.

A coating may be applied to protect a surface from undesirable surface activities. One known method of depositing a coating on a surface is chemical vapor deposition. Chemical vapor deposition deposits a solid material from a vapor under a controlled atmosphere and temperature conditions for a predetermined time to form a coating. Chemical vapor deposition can include a primary treatment followed by functionalization (a surface reaction) to add predetermined molecules.

To provide certain desired performance characteristics, an amorphous silicon hydride surface can be deposited and unsaturated hydrocarbon reagents can be reacted to modify the surface of a substrate. Amorphous silicon-based chemical vapor deposition materials, however, are susceptible to dissolution by caustic high pH media, thereby limiting their use. These materials are not wear resistant or hard enough for effective use in environments with impact or sliding wear. Additionally, the functionalization of silicon materials with unsaturated hydrocarbons often requires the use of a metal catalyst. Such processes suffer from the drawbacks that complete removal of this catalyst from the treated system is often difficult and the presence of the catalyst can reintroduce undesirable surface activity.

Molecules including silicon, carbon, and hydrogen have previously been considered undesirable for use as chemical vapor deposition precursors or have been applied in conjunction with other chemical vapor deposition precursors in the presence of additional depositional energies such as plasma and microwave fields. Thus, properties associated with such molecules have previously been unrealized through thermal chemical vapor deposition technology. Shinohara, M. et al. (Applied Surface Science, Vol. 175-176, 2001, p. 591-596 discloses the carbon incorporation during chemical vapor deposition of SiC using methylsilanes at low pressures. Narita et al. (Applied Surface Science, Vol. 252, no. 10, 2006, p. 3460-3465 discloses the growth of cubic silicon carbide (3C-SiC) using dimethylsilane as a source gas.

EP 0 812 013 A2 discloses formation of silicon carbide by chemical vapour deposition of alkylsilanes.

What is needed is a coating, an article, and a method that does not suffer from the drawbacks of the prior art.

### SUMMARY OF THE INVENTION

In this context the invention provides a thermal vapour deposition method as defined in the appended claims.

In the following disclosure the term "exemplary embodiment" relates to all disclosed embodiments. The disclosed embodiments exemplify the claimed invention only in so far as they fall within, or directly result from the method as defined in the claims.

An exemplary embodiment includes a thermal chemical vapor deposition coating. The thermal chemical vapor deposition coating comprises a thermal decomposition of dimethylsilane.

Another exemplary embodiment includes a thermal chemical vapor deposition method. The method includes preparing a substrate in a chemical vapor deposition chamber and thermally decomposing dimethylsilane in the chemical vapor deposition chamber to form a coating.

Another exemplary embodiment includes a chemical vapor deposition article. The article includes a surface and a layer formed on the surface of the article by thermal decomposition of dimethylsilane in a chemical vapor deposition chamber. The layer includes a first portion and a second portion defined by molecules deposited on the layer.

The molecules defining the first portion and the second portion include H, C, and Si-containing molecular fragments.

An advantage of an embodiment is that previously unavailable molecules including silicon, carbon, and hydrogen can be applied to substrate surfaces.

Another advantage of an embodiment is that thermal chemical vapor deposition can be performed without additional decompositional energies, such as plasma and microwave energies, to assist in decomposition of dimethylsilane.

Another advantage of an embodiment is that the silicon, carbon, and hydrogen material is not susceptible to dissolution in high pH media.

Another advantage of an embodiment is that the oxidized materials display an improved wear resistant and hardness for improved use in environments with impact or sliding wear.

Another advantage of an embodiment is that use of an additional metal catalyst can be avoided in the formation of a coating including silicon, carbon, and hydrogen.

Another advantage of an embodiment is that residual catalyst activity is reduced or eliminated.

Another advantage of an embodiment is that steps for removal of catalyst can be eliminated.

Another advantage of an embodiment is the use of a non-pyrophoric substance that can improve safety.

Further aspects of embodiments of the invention are disclosed herein. The features as discussed above, as well as other features and advantages of the present application, will be appreciated and understood by those skilled in the art from the following drawings and detailed description.

### BRIEF DESCRIPTION OF THE DRAWINGS

FIG. 1 shows an exemplary embodiment of a carbosilane coating on a substrate according to the disclosure.
FIG. 2 shows an Auger Electron Spectroscopy plot for an exemplary embodiment of a carbosilane coating having a layer on a substrate according to the disclosure.
FIG. 3 shows an exemplary embodiment of a functionalized carbosilane coating on a substrate according to the disclosure.
FIG. 4 shows a chemical vapor deposition method according to an exemplary embodiment of the disclosure.
FIG. 5 shows an exemplary treatment method in a chemical vapor deposition method according to the disclosure.
FIG. 6 shows an exemplary thermal decomposition in a chemical vapor deposition method according to the disclosure.
FIG. 7 shows an exemplary functionalization step in a chemical vapor deposition method according to the disclosure.
FIG. 8 shows an exemplary oxidation process in a chemical vapor deposition method according to an embodiment of the disclosure.
FIG. 9 shows an exemplary water oxidation process in a chemical vapor deposition method according to an embodiment of the disclosure.
FIG. 10 shows an FT-IR plot for a dimethylsilane deposited, functionalized surface and a dimethylsilane deposited, functionalized and water oxidized surface.
FIG. 11 shows an Auger Electron Spectroscopy plot for an exemplary embodiment of a coating having a water oxidized layer on a substrate according to the disclosure.

Wherever possible, the same reference numbers will be used throughout the drawings to represent the same parts.

### DETAILED DESCRIPTION

Provided is chemical vapor deposition coating, a chemical vapor deposition article, and a method of chemical vapor deposition that do not suffer from drawbacks of the prior art. For example, embodiments of the coating, article, and method can utilize molecules including silicon, carbon, and hydrogen. In one embodiment, the method can be employed without an additional metal catalyst, devoid of additional residual catalyst activity, and combinations thereof. In one embodiment, the method increases hardness without substantially reducing inertness, chemical corrosive resistance, and/or other desirable properties. Exemplary coatings formed according to the disclosure can modify functionality, inertness, tailorability, hydrophobicity, anticorrosive and/or anti-stiction behavior, hardness, wear resistance, or combinations thereof.

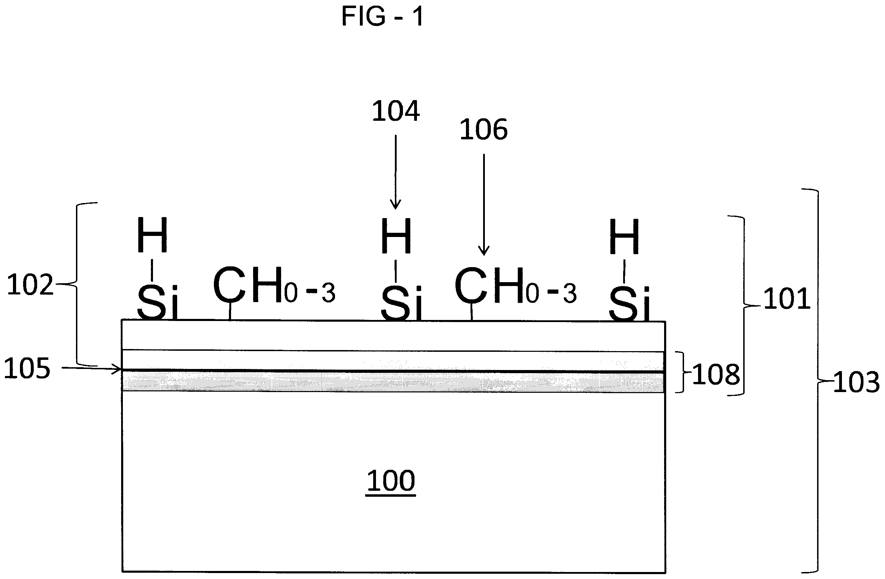

Referring to FIG. 1, a substrate 100 according to an exemplary embodiment can include a surface 105 having improved surface properties achieved by controllably depositing a layer 102 that imparts a desired surface effect to the substrate 100, a coating 101, an article 103, or combinations thereof. The coating 10 1 is formed by chemical vapor deposition (for example, decomposition of dimethylsilane to form a carbosilane) followed by oxidation (for example, air-oxidation to form a carboxysilane) and/or functionalization (for example, between a hydrosilane and an unsaturated hydrocarbon to form a functionalized carboxysilane).

The imparting of the desired surface effect can improve performance of the surface 105 by diffusion of the layer 102 and/or the coating 101 into the surface 105 of the substrate 100. The layer 102 can be applied to any suitable substrate. For example, the substrate 100 can be a metallic substrate (ferrous or non-ferrous), a glass substrate, or a ceramic substrate.

In an exemplary embodiment, the layer 102 is formed by thermal decomposition of dimethylsilane. By thermally decomposing dimethylsilane, the layer 102 includes molecules including silicon, carbon, and hydrogen atoms that can be active sites. These molecules within the layer 102 can include a first portion 104 and a second portion 106. Generally, the first portion 104 and the second portion 106 are not spatially resolvable (for example, the first portion 104 and the second portion 106 are defined by the molecules deposited on the layer 102 and the molecules may be interspersed throughout the layer 102). Furthermore, use of the terms "first" and "second" is not intended to imply any sequentiality, difference in quantity, difference in size, or other distinction between the two portions. To the contrary, the terms "first" and "second" are used for distinguishing molecular composition of the two portions. For example, in one embodiment, the first portion 104 includes silicon and the second portion 106 includes carbon. In one embodiment, the first portion 104 and the second portion 106 are bound together randomly throughout the layer 102.

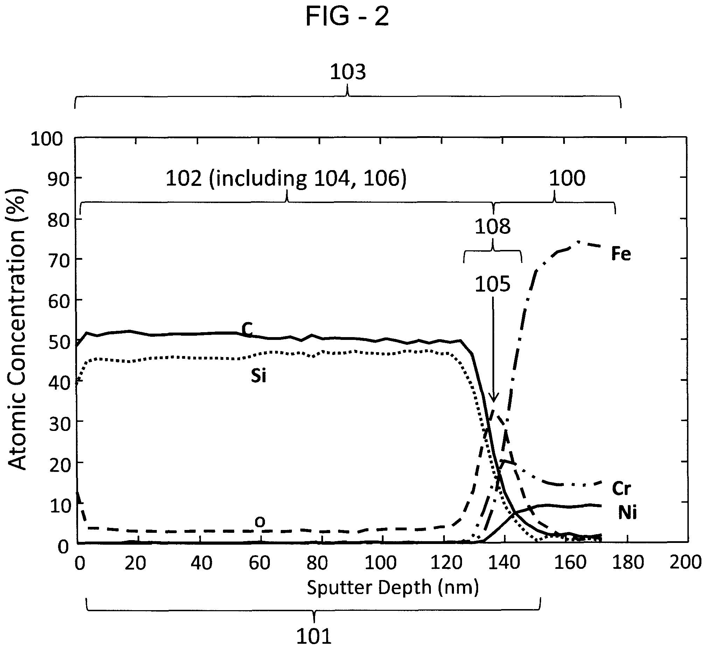

FIG. 2 illustrates diffusion of the layer 102 and/or the coating 101 into the substrate 100 according to an exemplary embodiment. Applying dimethylsilane to preselected surfaces has resulted in improved chemical resistance, improved inertness, and improved adhesion over non-diffusion coatings. FIG. 2 corresponds to the layer 102 having the first portion 104 with carbon and the second portion 106 having silicon. Specifically, FIG. 2 shows the composition of the layer 102 within the substrate 100 and/or the article 103 by Auger Electron Spectroscopy measurements of the layer 102.

In one embodiment, dimethylsilane is thermally decomposed and deposited as amorphous carbosilane for 15 hours. In this embodiment, the layer 102 extends to about 130 nanometers and includes a portion of the diffusion region 108 identifiable based upon an increased concentration of 0 and decreased in concentration of C and Si (for example, by at least a factor of four). The range of the layer 102 can be between about 0.1 micrometers to about 3.0 micrometers. The diffusion region 108 can be between about 5 nanometers and 500 nanometers. In one embodiment, the diffusion region 108 is about 20 nanometers. The composition of layer 102 is about 1:0.95:0.12 ratio of C:Si:O (the small presence of oxygen from a depth of 5 nanometers to 120 nanometers is likely attributed to background noise and trace contamination). In contrast, the composition of dimethylsilane introduced into the chemical vapor deposition chamber has about a 2: 1 ratio of C:Si. It is believed that CHₓ (x = 0 - 3) moieties are retained and Si-C bonds are broken thus indicating that layer 102 includes an amorphous array of Si-C bonding and/or a polycrystalline microstructure. The amorphous array provides additional benefits such as decreased cracking or flaking (for example, upon tensile or compressive forces acting on the substrate 100) and/or increased adhesion. In one embodiment, multiple layers of the coating 101 or similar coatings are deposited for thicker layers or for desired properties.

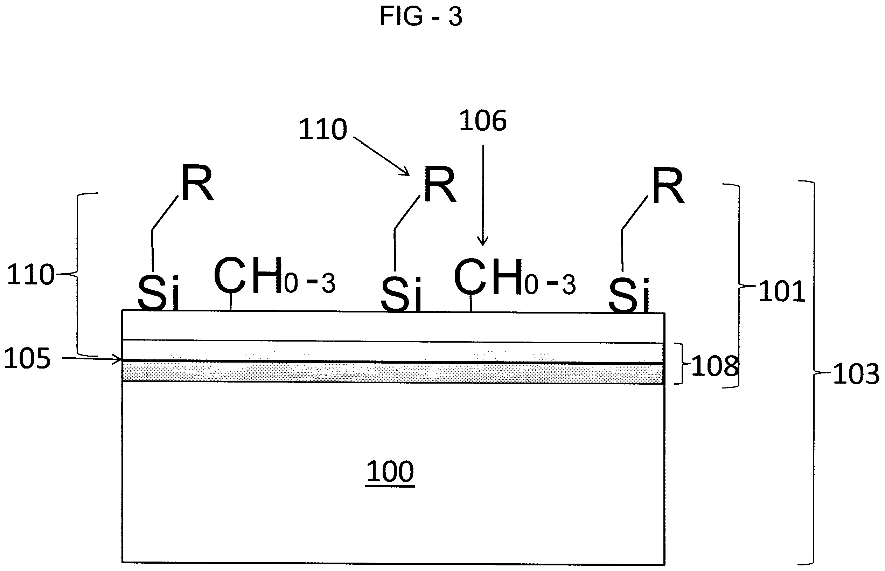

FIG. 3 shows an exemplary embodiment having a functionalized layer 110. The functionalized layer 110 is formed by thermally reacting silicon hydride moieties with unsaturated hydrocarbons (for example, having the formula H2C=CH-R and/or HC=C-R) and includes R-groups bonded to all or part of first portion 104 of the layer 102. R-groups can be formed by any suitable organic reagent having one or more unsaturated hydrocarbon groups. R -groups can be formed by hydrocarbons, substituted hydrocarbons (for example, halogenated), carbonyls, carboxyls, esters, amines, amides, sulfonic acids, organometallic complexes, and/or epoxides.

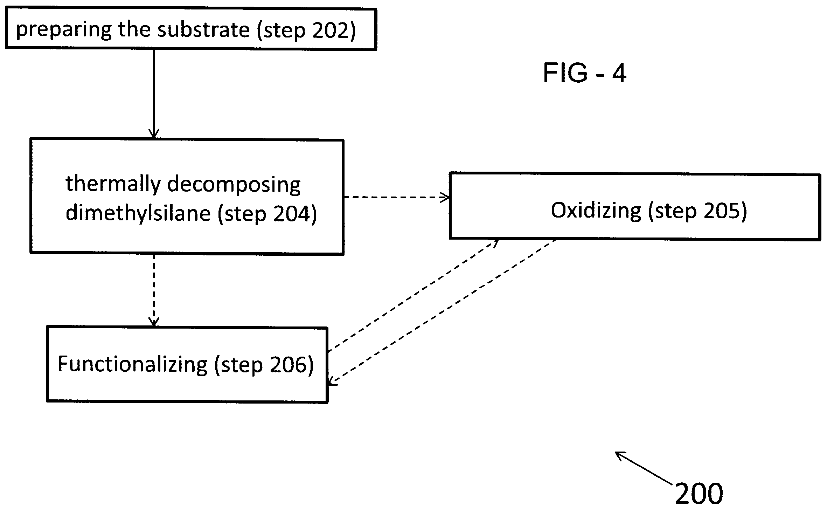

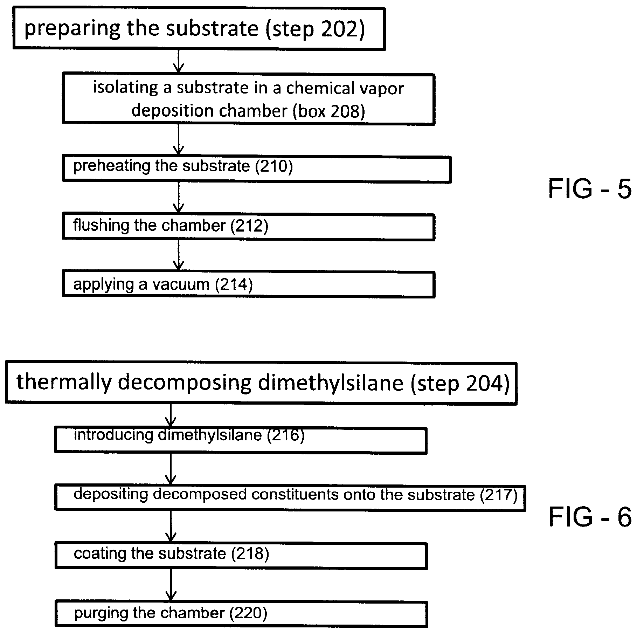

FIG. 4 shows an exemplary chemical vapor deposition method 200 for forming the layer 102 that includes preparing the substrate (step 202) and thermally decomposing dimethylsilane (step 204). Preparing the substrate (step 202 can be performed by any suitable treatment method. For example, referring to FIG. 5, preparing the substrate (step 202) can include isolating a substrate in a chemical vapor deposition chamber (substep 208), preheating the substrate (substep 210), flushing the chamber (substep 212) with an inert gas, and evacuating the chamber (substep 214).

Isolating the substrate (substep 208) is performed in an inert atmosphere within the chamber. The flow of gas and/or maintenance of a vacuum in the chamber can provide the controlled atmosphere. A heat source can control the temperature in the chamber to desorb water and remove remaining contaminants from the substrate surface (substep 210). For example, the surface to be treated can be included within a chemical vapor deposition chamber with tubing connections to allow gas flow in and out of the chemical vapor deposition chamber. The chamber can include multiple controlled inlets and outlets configured for providing and removing multiple gas streams. A vacuum may be connected to one or more outlet tubes.

Depending upon the cleanliness of the substrate, the substrate may be prepared by heating (substep 210) at a temperature above about 100°C at a pressure of below about 1 atmosphere for a period ranging from a few minutes to about 15 hours. Generally, the temperature of the heating corresponds to the properties of the substrate 100. In one embodiment, the period is from about 0.5 to about 15 hours. In another embodiment, the substrate is heated at about 450°C for about 2 hours. After preparation under vacuum, the chamber may be selectively flushed (substep 212) with an inert gas and evacuated (substep 214).

Method 200 includes thermally decomposing the dimethylsilane (step 204). In general, dimethylsilane is not readily obtainable due to the low demand for it. Dimethylsilane has been regarded as undesirable in some chemical vapor deposition applications because it includes carbon. It has been found to produce lower wear resistance coatings when applied by conventional techniques, and is much more expensive than silane. Silane and the monomethyl analogue to dimethylsilane, methylsilane, are both pyrophoric and may explode in air. Dimethylsilane, although flammable, is not pyrophoric. Thus, use of dimethylsilane can decrease safety risks. In addition, use of dimethylsilane can result in inertness of a coating and/or chemical resistance, thereby protecting a surface of a substrate.

Referring to FIG. 6, thermal decomposition of dimethylsilane (step 204) includes introducing dimethylsilane (sub step 216) into the chamber at a predetermined pressure and temperature sufficient to decompose dimethylsilane, depositing constituents from decomposition onto the substrate 100 (substep 217), coating the substrate (substep 218) for a predetermined period of time to achieve a predetermined thickness, and/or purging the chamber of dimethylsilane (substep 220). As is described in U.S. Patent 6,444,326, which is incorporated herein by reference in its entirety, exemplary process conditions may include pressure being between about 6.8948×10⁻⁴ bar (0.01 p.s.i.a.) to about 13.789 bar (200 p.s.i.a.). The temperature can be between about 200° and 600°C. The time period can be from about 10 minutes to about 24 hours.

In one embodiment, the dimethylsilane introduced (substep 216) includes dimethylsilane in gaseous form. In one embodiment, the substrate is exposed to dimethylsilane gas at a pressure between about 6.8948×10⁻² bar (1.0 p.s.i.a.) and about 6.8948 bar (100 p.s.i.a.) and a temperature between about 300° and 600°C for a time of about 30 minutes to about 24 hours. In an exemplary embodiment, the substrate 100 is exposed to dimethylsilane gas at a temperature between about 400° and about 500°C for about 15 hours. The pressure of the dimethylsilane gas may be between about 3.4474×10⁻¹ bar (5 p.s.i.a.) and about 2.7579 bar (40 p.s.i.a.).

The dimethylsilane is then thermally dissociated into molecular fragments including H, C, Si, and combinations thereof, and the constituents are deposited onto the substrate 100 (substep 217), thereby forming the coating 102 (substep 218) with a material including silicon, carbon, and hydrogen resulting from decomposition of dimethylsilane. Dimethylsilane gas may be introduced into the reaction chamber under reduced pressure or with an inert gas, such as nitrogen, helium, and/or argon, as a partial pressure dilutant. Although not intending to be bound by theory, it is believed that the dimethylsilane thermally decomposes to form carbosilyl fragments, which recombine and bind to the substrate surface. It is believed that the resultant coating includes amorphous carbosilanes having carbon, silicon, and hydrogen on the substrate surface as well as on exposed surfaces of the chamber. The deposited material also diffuses into the surface 105 of the substrate 100 as is illustrated in the Auger Electron Spectroscopy depth profile (FIG. 2, the diffusion region 108) thus supporting the mode of adhesion to the substrate 100. The chamber may then be purged of dimethylsilane and volatile, non-deposited carbosilyl fragments (substep 220). If a thicker deposition layer is desired, deposition conditions are changed. This is accomplished by changing temperature, pressure, time, or combinations thereof. Multiple layers can also be applied by repeating step 204.

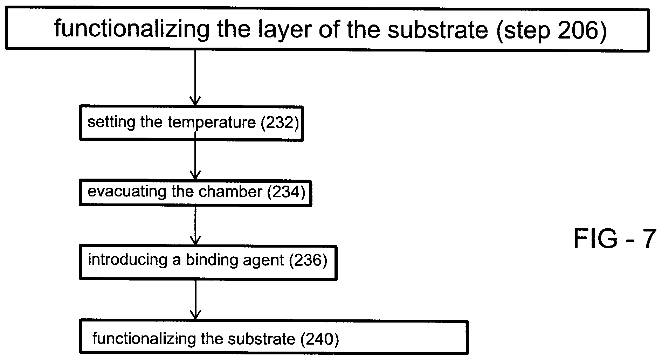

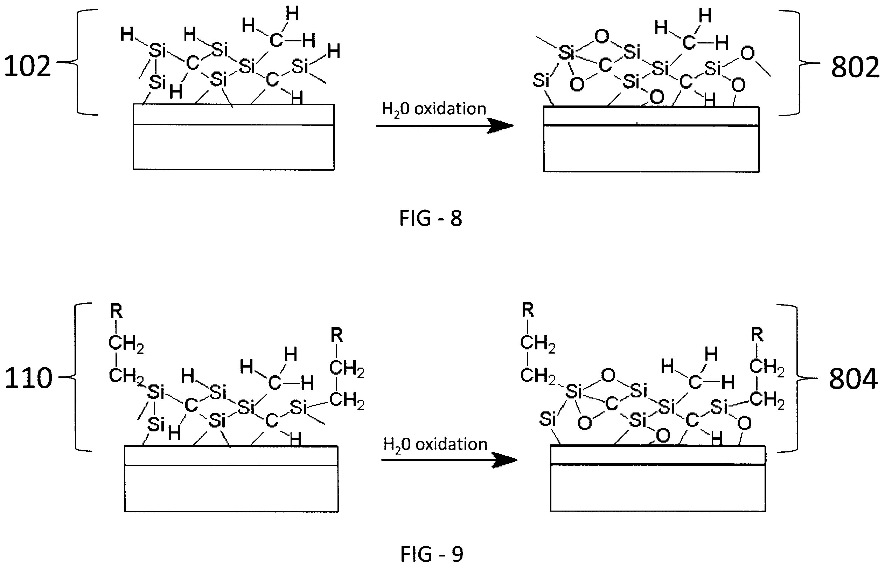

Upon the layer 102 (as further described with reference in FIGS. 1 and 2) being formed, additional steps may be performed. In one embodiment, the layer 102 is functionalized next (step 206) as further described below with reference to FIG. 7 to form the functionalized layer 110. In one embodiment, the layer 102 (for example, amorphous carbosilane) is oxidized (step 205) as further described below with reference to FIG. 8 to form an oxidized layer 802 (for example, amorphous carboxysilane). In one embodiment, the functionalized layer 110 (for example, functionalized amorphous carbosilane) is oxidized to form a functionalized then oxidized layer 804 (for example, functionalized amorphous carboxysilane) as further described below with reference to FIG. 9. In one embodiment, the oxidized layer 802 is functionalized.

In one embodiment, the method 200 further includes functionalizing the layer 102 of the substrate 100 (step 206) to form the functionalized layer 110, as briefly discussed above with reference to FIG. 3. Referring to FIG. 7, functionalizing the layer 102 of the substrate 100 (step 206) may be performed by reacting with silicon hydride moieties remaining from the original carbosilane deposition (step 204). Following the carbosilane deposition on the substrate (step 204), the system is purged with an inert gas (which can be the purging of substep 220 or a separate purge step) while the reaction chamber can be set to a predetermined functionalization temperature (sub step 232). The purge removes gaseous carbosilane moieties and/or unreacted dimethlysilane moieties not bound to the substrate surface. After the purge and setting of the temperature (substep 232), the chamber is evacuated (substep 234).

Next, a binding agent is introduced into the chamber at a predetermined temperature and pressure within the chamber (substep 236). In one embodiment, with heat as a driving force, the binding reagent reacts with and binds to the carbosilyl surface via silicon hydride moieties. Binding agent examples are ethylene, propylene, and substituted unsaturated organic molecules. Residual moieties of the silicon hydride may be reacted under heat (for example, at about 400°C) with H₂C=CH-R and/or HC=C-R. The R-groups can be formed by hydrocarbons, substituted hydrocarbons (for example, halogenated), carbonyls, carboxyls, esters, amines, amides, sulfonic acids, organometalic complexes, and/or epoxides.

In one embodiment, binding agent molecules are then bound to the substrate (substep 240). The coating can include a carbon-silicon covalent bond with an R-group. The R-group can be modified to adjust the properties of the surface. For example, the R-group can be modified to adjust the hydrophobicity of the surface. To adjust the hydrophobicity of the surface, the R-group can be a fluorinated hydrocarbon. The fluorinated hydrocarbon can form a hydrophobic and/or oleophobic surface. Additionally or alternatively, the R-group can include an organometallic substituent providing catalytic or biocidal properties. Although not intending to be bound by theory, it is believed that the moieties of silicon hydride can thermally react, via a hydrosilyation mechanism, with unsaturated hydrocarbon groups to covalently bond to the surface of the coated substrate. The resultant coating on all exposed surface within the reaction chamber includes covalently-bound R-groups which includes the R-group and carbon, silicon, and hydrogen moieties.

In one embodiment, method 200 further includes oxidizing the layer 102 of the substrate 100 (step 205) to form the oxidized layer 802 as briefly described above with reference to FIG. 3. In another embodiment, the functionalized layer 110 is oxidized. Layer 102 is oxidized by exposure to any suitable chemical species capable of donating a reactive oxygen species into layer 102 under predetermined oxidation conditions. For example, the chemical species may be water, oxygen, air, nitrous oxide, ozone, peroxide, and combinations thereof. In general, oxidation is a bulk reaction that affects the bulk of the coating 10 1. The oxidation may be controlled by increasing or decreasing the temperature within the chamber, the exposure time within the chamber, the type and/or amount of diluent gases, pressure, and/or other suitable process conditions. Control of the oxidation can increase or decrease the amount and/or depth of oxidation and, thus, the wear resistance and/or hardness of the surface. In one embodiment, the layer 102 is exposed to water (for example, in an inert gas at a pressure of about 6.8948 to 13.7896 bar (100 to 200 p.s.i.a.) at about 450°C for about two hours). In one embodiment, the functionalized layer 110 is exposed to water (for example, in an inert gas at a pressure of about 6.8948 to 13.7896 bar (100 to 200 p.s.i.a.) at about 450°C for about two hours).

The oxidation improves hardness and/or wear resistance of carbosilane and functionalized carbosilane-based chemical vapor deposition process materials on ferrous metallic surfaces, non-ferrous metallic surfaces, and/or glass surfaces by controlled oxidation. In one embodiment, referring to FIG. 8, the layer 102 is an amorphous layer of carbosilane that is oxidized to form an amorphous layer of carboxysilane as the oxidized layer 802. In one embodiment, referring to FIG. 9, the functionalized layer 110 is an amorphous layer of functionalized carbosilane that is oxidized to form an amorphous surface of functionalized carbosilane that is oxidized to form an amorphous surface of functionalized carboxysilane as the oxidized layer 802.

In one embodiment, the oxidizing (step 205) is performed with nitrous oxide (N20). Specifically, N₂0 is applied under heat (for example, about 450°C) with a pressure of substantially pure N₂0 in a vessel with carbosilane-coated samples. In this embodiment, the oxidizing (step 205) over-oxidizes and the over-oxidizing results in having a contact angle of about 60°, increases an amount of N-H, Si-OH, and/or C-OH groups, and results in having relatively fragile scratch resistance.

In one embodiment, the oxidizing (step 205) is performed with ozone. In this embodiment, the oxidizing (step 205) is believed to decrease wear resistance, decrease chemical resistance, decrease scratch resistance, decrease hardness, and increase acid resistance / corrosion resistance.

In one embodiment, the oxidized layer 802 is formed with water (only) as an oxidizing reagent (for example, within a temperature range of about 100°C to about 600°C, a temperature range of about 300°C to about 600°C, or at a temperature of about 450°C). In this embodiment, the oxidizing (step 205) results in having a contact angle on a Si wafer of about 86.6°, lowers friction (in comparison to using an oxidizing reagent of air and water), decreases wear resistance (for example, in comparison to using an oxidizing reagent of air and water), and forms Si-O-Si groups.

In another embodiment, the oxidized layer 802 is formed with an oxidizing reagent including air and water (for example, within a temperature range of about 100°C to about 600°C, a temperature range of about 300°C to about 600°C, or at a temperature of about 450°C). In this embodiment, oxidizing (step 205) over-oxidizes and decreases an amount of C-H groups (for example, in comparison to using water alone as an oxidizing reagent), decreases an amount of Si-C groups (for example, in comparison to using water alone as an oxidizing reagent), and increases an amount of Si-OH/C-OH groups (for example, in comparison to using water alone as an oxidizing reagent).

In another embodiment, the oxidized layer 802 is formed with air (only) (for example, within a temperature range of about 100°C to about 600°C, a temperature range of about 300°C to about 600°C, or at a temperature of about 450°C). In this embodiment, oxidizing (step 205) lowers friction, increases wear resistance (for example, in comparison to using an oxidizing reagent of water), and forms Si-O-Si and Si-OH groups.

In one embodiment, the layer 102 has a predetemined contact angle (for example, about 98.3° advancing) and the functionalized layer 110 has a higher contact angle (for example, about 100° advancing). In one embodiment, the layer 102 has a predetermined contact angle (for example, about 95.6° advancing) and a functionalized then oxidized layer 804 has a lower contact angle (for example, about 65.9° receding). In this embodiment, the oxidizing (step 205) forms Si-O-Si groups decreasing an amount of Si-H groups (for example, in comparison to the functionalized layer 110).

In one embodiment, the layer 802 has a lower coefficient of friction (for example, about 0.84) than a higher coefficient of friction (for example, about 0.97) for the layer 102. Similarly, in one embodiment, the oxidized layer 802 has a lower wear rate (for example, about 6.75 E-05 mm³/N/m) than a higher wear rate (for example, 4.73 E-04 mm³/N/m) for the layer 102.

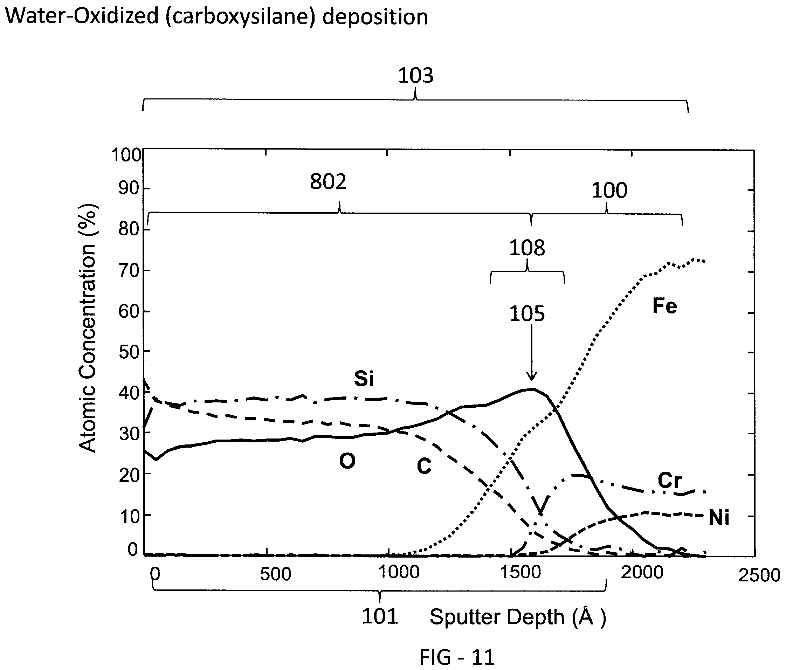

FIG. 11 illustrates diffusion of the water oxidized layer 802 into the substrate 100 (for example, stainless steel) according to an exemplary embodiment. Specifically, FIG. 11 shows the composition of the water oxidized layer 802 within the substrate 100, the coating 101, and the article 103 by Auger Electron Spectroscopy. As shown, the oxidation is illustrated by Si-H moieties undergoing oxidation and elimination to create Si-O-Si linkages, as well as some Si-C and/or free carbon species being eliminated as well. In one embodiment, the oxidized layer 802 extends to about 1600 Angstroms and includes the diffusion region 108 being about 250 Angstroms, identifiable based upon a decreased concentration of C and Si. The range of the water oxidized layer can be between about 0.1 micrometers and about 3.0 micrometers. The diffusion region 108 can be between about 5 nanometers and 500 nanometers. The composition of the water oxidized layer 802 is about 1.0:1.22:0.91 (C:Si:O) with an increase in Oxygen due to the preexisting oxide layer on substrate 100.

### EXAMPLE 1

The first example included introducing dimethylsilane to the substrate 100 for 2 hours at 5.5158x10⁻¹ bar (8 p.s.i.a.) gas at 450°C to form the layer 102. In the first example, the layer 102 was almost undetectable (i.e., very difficult to visually discern) on a mirror-polished 316 stainless steel coupon (slightly yellowed). Measurements showed water contact angle data prior to the deposition treatment at around 60°. After the deposition treatment with dimethylsilane, the contact angle increased to around 102°. Although the layer 102 was not visible, the data indicated an extremely thin deposition with a significant density of carbosilyl material on the layer 102 of the surface 105. The thickness of the layer 102 was estimated to be at about 100 Angstroms as available spectroscopic techniques were not sensitive enough to detect the coating.

### EXAMPLE 2

The second example included introducing dimethylsilane to the substrate 100 for 15 hours at 5.5158x10⁻¹ bar (8 p.s.i.a.) gas at 450°C to form the layer 102. In the second example, the layer 102 had a visible luminescent rainbow array of colors. Measurements showed average deionized water contact angle data around 100°, for mirror-finished 316 stainless steel surfaces and polished silicon wafer surfaces. FT-IR indicated presence of C-H based upon a reading at 2950 cm⁻¹, the presence of Si-C based upon a reading at 792 cm⁻¹, and the presence of Si-H moieties based upon a reading at 2102 cm⁻¹. The thickness of the layer 102 was determined by spectrometer to be about 800 Angstroms. Further measurements utilizing Auger Electron Spectroscopy were also performed. The measurements showed increased concentrations of Si and C atoms on the layer 102. The measurement further showed the concentration of Si and C atoms decreasing upon reaching the diffusion region 108 illustrated by the increase in concentration of Fe, Cr, and Ni atoms. The measurement showed the concentration of Si and C atoms being asymptotic with zero upon reaching a point beyond the diffusion region 108. The measurement also showed that the diffusion region 108 can be identified based upon the concentration of 0 atoms being elevated (the result of a surface oxide on the surface 105 of the substrate 100 prior to deposition).

### EXAMPLE 3

The third example included introducing dimethylsilane to the substrate 100 for 15 hours at 5.5158x10⁻¹ bar (8 p.s.i.a.) gas at 450°C to form the layer 102 and subsequently oxidizing the layer 102 of the substrate 100 with water in an inert gas for 2 hours at about 6.8948 to 13.7896 bar (100 to 200 p.s.i.a.) gas at 450°C to form the oxidized layer 802. FT-IR data failed to reveal the significant presence of any functional moieties (Si-OH or Si-H) for surface modification chemistry. The resultant carboxysilane material revealed an improvement in hardness and wear resistance over the native carbosilane. The oxidized layer 802 had a contact angle on a Si wafer of 86.6°, and an increased presence of Si-O-Si groups.

### EXAMPLE 4

The fourth example included introducing dimethylsilane to the substrate 100 for 15 hours at 5.5158x10⁻¹ bar (8 p.s.i.a.) gas at 450°C to form the layer 102 and subsequently oxidizing the layer 102 of the substrate 100 with an oxidation reagent mixture for 2 hours at about 6.8948 to 13.7896 bar (100 to 200 p.s.i.a.) gas at 300°C to form the oxidized layer 805. The oxidation reagent mixture included air and water. According to FT-IR data, the oxidized layer 805 had a decrease of C-H groups (in comparison to Example 3), a decrease of SiC groups (in comparison to Example 3), and an increase of Si-OH groups (in comparison to Example 3).

### EXAMPLES

The fifth example included introducing dimethylsilane to the substrate 100 for IS hours at 5.5158x10⁻¹ bar (8 p.s.i.a.) gas at 450°C to form the layer 102 and subsequently oxidizing the layer 102 on the substrate 100 with air for 2 hours at about 6.8948 to 13.7896 bar (100 to 200 p.s.i.a.) gas at 300°C to form the oxidized layer 805. The fifth example produced an oxidized carbosilane material with a significant Si-OH stretch observed in the FT-IR data (broad; 3414 cm⁻¹). Contact angle was measured to be 50.9° for deionized water. Electrochemical impedance spectroscopy showed impedance at low frequency Z_{if} = about 7.27 kohm. Wear resistance of the material was analyzed with a Tribometer (CSM Instruments S/N 18-343) applying a 0.5 N force via a standard 100 Cr6 ball and circular linear speed of 3.00 cm/s thereby showing a 4.141e⁻⁰³ wear (mm³/N m). The oxidized layer 805 had lower friction (in comparison to Example 3), higher wear resistance (in comparison to Example 3), and a presence of Si-O-Si groups.

### EXAMPLE 6

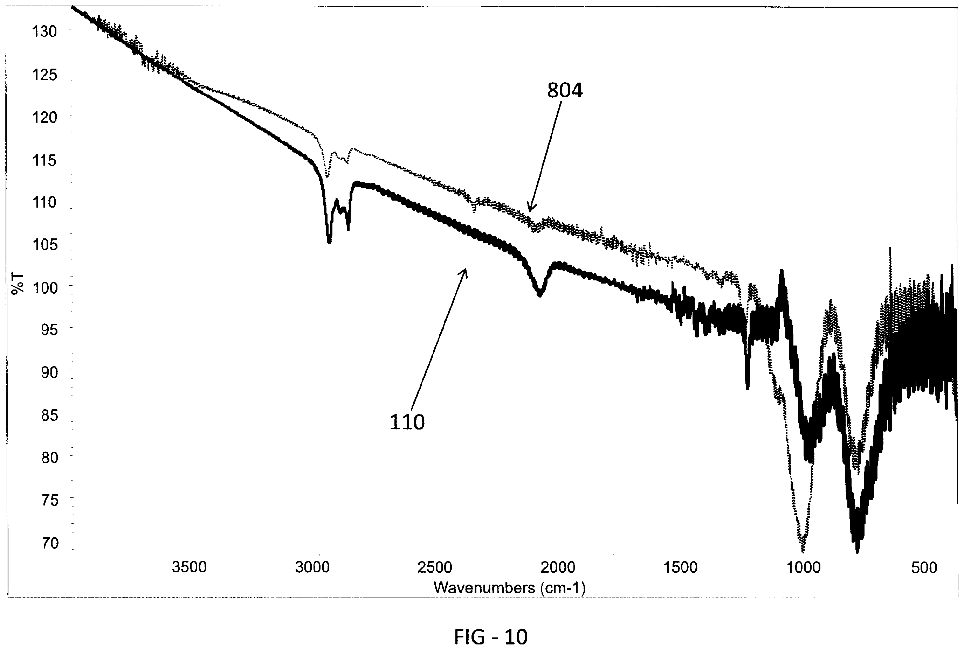

The sixth example included functionalizing the layer 102 formed in Example 2 with ethylene to form the functionalized layer 110. The functionalized layer 110 had a water contact angle of 98.3° advancing and 85.1° receding. As shown in FIG. 10, FT-IR data showed little oxidation occurred based upon a lack of Si-O-Si groups (based upon a stretch at 1027 cm⁻¹) and decreased an amount of Si-H groups (based upon a stretch at 2091 cm⁻¹).

### EXAMPLE 7

The seventh example included functionalizing the layer 102 formed in Example 2 with ethylene to form the functionalized layer 110. Then, the functionalized layer 110 was oxidized by 5 ml deionized water (DI) being added to the chamber. The chamber was exposed to several nitrogen flushes and mild vacuum to remove air from the sealed container. The temperature in the chamber was held at 450°C for about 2 hours and then returned to room temperature. The oxidation of the functionalized layer 110 formed the functionalized then oxidized layer 804. The functionalized then oxidized layer 804 had a water contact angle data of 95.6° advancing and 65.9° receding. As shown in FIG. 10, FT-IR showed oxidation increased an amount of Si-O-Si groups (based upon a stretch at 1027 cm⁻¹) and decreased an amount of Si-H groups (based upon a stretch at 2091 cm⁻¹) in comparison to the functionalized layer 110 formed in Example 6.

## Claims

1. A thermal chemical vapor deposition method (200), the method (200) comprising:
preparing (202) a substrate (100) in a chemical vapor deposition chamber;
thermally decomposing (204) dimethyl silane in the chemical vapor deposition chamber to form a coating (102), the thermal decomposition being performed in the absence of additional deposition energies such as plasma and microwave fields, and under the following conditions:
- at a pressure of between 6.8948×10⁻² bar (1.0 p.s.i.a.) and 6.8948 bar (100 p.s.i.a.), preferably at a pressure of between 3.4474x10⁻¹ bar (5 p.s.i.a.) and about 2.7579 bar (40 p.s.i.a.); and
- at a temperature between 300°C and 600°C; and
- for a time of 30 minutes to 24 hours.

2. The method (200) of claim 1, wherein the dimethyl silane introduced into the chemical vapor deposition chamber includes gaseous dimethylsilane.

3. The method (200) of claim 1, further comprising functionalizing (206) at least a portion of the coating (102) by introducing a binding agent to form a functionalized layer (110).

4. The method (200) of claim 3, wherein the functionalizing (206) is performed by reacting the surface with silicon hydride moieties remaining from an original carbosilane deposition provided by the thermal decomposition (204) of dimethylsilane.

5. The method (200) of claim 3, further comprising oxidizing (205) at least a portion of the functionalized layer (110) by applying an oxidizing reagent.

6. The method (200) of claim 1, further comprising oxidizing (205) at least a portion of the coating (102) by applying an oxidizing reagent.

## Patentansprüche

1. Thermisch-chemisches Gasphasenabscheidungsverfahren (200), wobei das Verfahren (200) umfasst:
Herstellen (202) eines Substrats (100) in einer chemischen Gasphasenabscheidungskammer;
thermisches Zersetzen von (204) Dimethylsilan in der chemischen Gasphasenabscheidungskammer unter Bildung einer Beschichtung (102), wobei die thermische Zersetzung in Abwesenheit zusätzlicher Abscheidungsenergien wie Plasma- und Mikrowellenfelder und unter den folgenden Bedingungen durchgeführt wird:
- bei einem Druck zwischen 6,8948×10⁻² bar (1,0 psia) und 6,8948 bar (100 psia), vorzugsweise bei einem Druck zwischen 3,4474×10⁻¹ bar (5 psia) und etwa 2,7579 bar (40 psia); und
- bei einer Temperatur zwischen 300 °C und 600 °C; und
- für eine Zeit von 30 Minuten bis 24 Stunden.

2. Verfahren (200) nach Anspruch 1, wobei das in die chemische Gasphasenabscheidungskammer eingebrachte Dimethylsilan gasförmiges Dimethylsilan einschließt.

3. Verfahren (200) nach Anspruch 1, ferner umfassend das Funktionalisieren (206) mindestens eines Teils der Beschichtung (102) durch Einbringen eines Bindemittels zur Bildung einer funktionalisierten Schicht (110).

4. Verfahren (200) nach Anspruch 3, wobei die Funktionalisierung (206) durch Umsetzen der Oberfläche mit Siliciumhydrideinheiten durchgeführt wird, die von einer ursprünglichen Carbosilanabscheidung zurückbleiben, die durch die thermische Zersetzung (204) von Dimethylsilan bereitgestellt wird.

5. Verfahren (200) nach Anspruch 3, ferner umfassend das Oxidieren (205) mindestens eines Teils der funktionalisierten Schicht (110) durch Aufbringen eines Oxidationsreagens.

6. Verfahren (200) nach Anspruch 1, ferner umfassend das Oxidieren (205) mindestens eines Teils der Beschichtung (102) durch Aufbringen eines Oxidationsreagens.

## Revendications

1. Procédé de dépôt thermochimique en phase vapeur (200), le procédé (200) comprenant :
la préparation (202) d'un substrat (100) dans une chambre de dépôt chimique en phase vapeur ;
la décomposition thermique (204) du diméthylsilane dans la chambre de dépôt chimique en phase vapeur pour former un revêtement (102), la décomposition thermique étant effectuée en l'absence d'énergies de dépôt supplémentaires telles que des champs de plasma et de micro-ondes et dans les conditions suivantes :
- à une pression comprise entre 6,8948×10⁻² bar (1,0 psia) et 6,8948 bar (100 psia), de préférence à une pression comprise entre 3,4474 × 10⁻¹ bar (5 psia) et environ 2,7579 bar (40 psia) ; et
- à une température comprise entre 300 °C et 600 °C ; et
- pour une durée de 30 minutes à 24 heures.

2. Procédé (200) selon la revendication 1, dans lequel le diméthylsilane introduit dans la chambre de dépôt chimique en phase vapeur inclut du diméthylsilane gazeux.

3. Procédé (200) selon la revendication 1, comprenant en outre la fonctionnalisation (206) d'au moins une partie du revêtement (102) en introduisant un agent liant pour former une couche fonctionnalisée (110).

4. Procédé (200) selon la revendication 3, dans lequel la fonctionnalisation (206) est effectuée en faisant réagir la surface avec des groupements d'hydrure de silicium restant d'un dépôt de carbosylane d'origine fourni par la décomposition thermique (204) du diméthylsilane.

5. Procédé (200) selon la revendication 3, comprenant en outre l'oxydation (205) d'au moins une partie de la couche fonctionnalisée (110) en appliquant un réactif oxydant.

6. Procédé (200) selon la revendication 1, comprenant en outre l'oxydation (205) d'au moins une partie du revêtement (102) en appliquant un réactif oxydant.
